# EUROPEAN PATENT SPECIFICATION

(11) **EP 0 492 653 B1**
(45) Date of publication and mention of the grant of the patent: **19.06.1996**
(21) Application number: 91122302.2
(22) Date of filing: 27.12.1991
(51) Int. Cl.: H03H 7/01

(54) **Printed filter for use in high-frequency circuit**
Gedruckter Filter zur Anwendung in einer Hochfrequenzschaltung
Filtre imprimé pour utilisation dans un circuit à hautes fréquences

(30) Priority: 28.12.1990 JP 408846/90
(43) Date of publication of application: 01.07.1992
(73) Proprietor: MATSUSHITA ELECTRIC INDUSTRIAL CO., LTD., Kadoma-shi, Osaka-fu, 571 (JP)
(72) Inventor: Kubo, Kazuhiko, Mishima-gun, Osaka (JP); Konishi, Takaaki, Ibaraki-shi, Osaka (JP)
(74) Representative: Dipl.-Phys.Dr. Manitz Dipl.-Ing. Finsterwald Dipl.-Ing. Grämkow Dipl.Chem.Dr. Heyn Dipl.Phys. Rotermund Morgan, B.Sc.(Phys.)

(56) References cited:
- DE-B- 1 227 531
- FR-A- 2 568 742
- US-A- 4 888 568
- PATENT ABSTRACTS OF JAPAN vol. 11, no. 108 (E-495)(2555) 4 April 1987 & JP-A-61 256 611
- QST AMATEUR RADIO. vol. 54, no. 4, April 1970, NEWINGTON US page 44; 'DESIGN OF PRINTED-CIRCUIT COILS'

## Description

### BACKGROUND OF THE INVENTION

The present invention relates to a printed filter formed on a printed board to be effective for use in a high-frequency circuit such as television tuner.

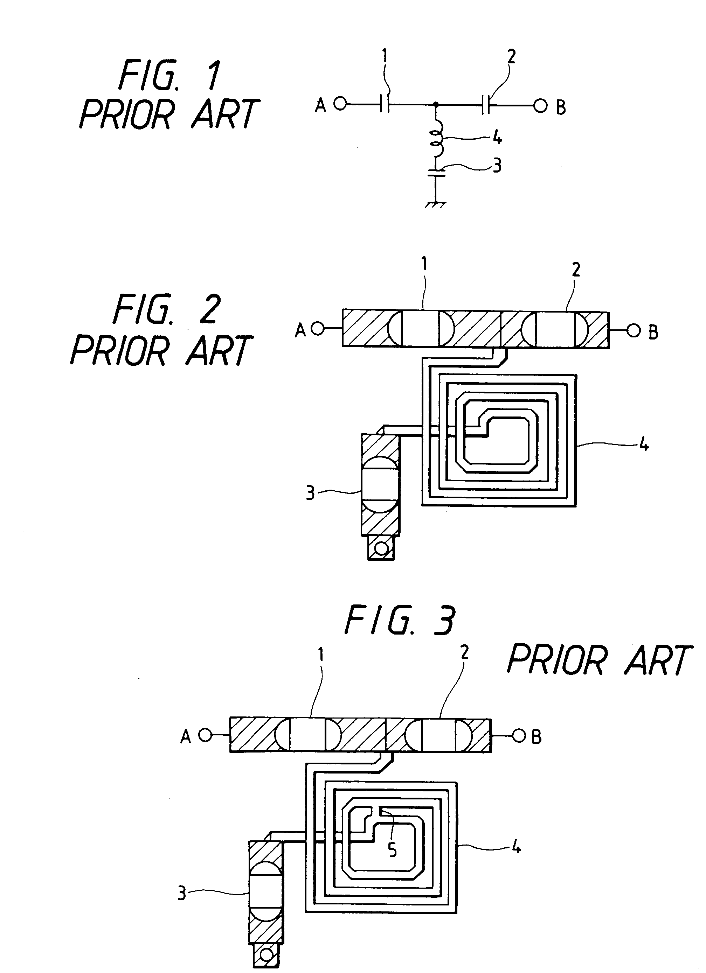

Recently, for constructing a filter in a high-frequency circuit such as tuner, elements such as coils and capacitors tend to be constructed with printed patterns. A prior art printed filter will be made hereinbelow with reference to Figs. 1 and 2, Fig. 1 being an illustration of an arrangement of a polar tertiary high-pass filter circuit in which numerals 1 to 3 respectively represent capacitors, 4 designates a coil and characters A and B are input and output terminals, and Fig. 2 is an illustration of a printed pattern on a printed board corresponding to the Fig. 1 circuit. In Fig. 2, the capacitor 1 to 3 are respectively constructed as chip capacitors and the coil 4 is a spiral-shaped coil formed by a printed foil on the printed board. The rear surface of the printed board is entirely formed with a ground foil constructed by a printed foil so that one terminal of the capacitor 3 is connected through a through-hole to the rear surface thereof to be grounded.

There is a problem which arises with such a filter arrangement, however, in that the filter characteristic tends to be different from a desired value due to the dispersion between parts, variation of the width of the printed foil, and others.

From Patent abstracts of Japan Vol 11, No. 108 (E-495) (255) April 4, 1987 concerning the production of a variable chip-type inductor it is known to adjust the value of inductance with the cutting of a short-circuit pattern and short-circuting of a pattern while using a magnetic substrate so as to make the value of inductance larger. Independent coil patterns are formed on both surfaces of the magnetic substrate. The end sections of the two coil patterns are drawn out to the side surface of the magnetic substrate so as to form terminal patterns and plural short-circuit patterns are provided at least on any coil pattern so that the short-circuit pattern can be cut. When the inductance between two terminals is to be increased, the short circuit pattern is cut with trimming etc., and when the inductance is to be decreased, the patterns between the coil patterns are connected with bonding, etc. Thus a wide range inductance is obtained with the patterns on the two surfaces of the magnetic substrate connected serially and parallel.

FR-A-2568742 refers to an adjustable inductance in form of a printed circuit. It is suggested to form the inductance by a circuit printed on a single- or double-sided circuit board. The circuit is constituted by a coil pattern. In the innermost winding, a plurality of terminals is provided which allow for short circuiting of the coil so that the length of the coil can be adjusted.

Thus, the prior art suggests to adjust the filter characteristic in a printed filter comprising a spiral coil formed on a printed board. However, the adjustment effected in the prior art does not allow adjustment in the fine range.

### SUMMARY OF THE INVENTION

It is therefore an object of the present invention to provide a printed filter that allows for improved adjustment of the filter characteristic if required.

This object is achieved by a printed filter according to claim 1.

A preferred embodiment is described in the dependent claim.

### BRIEF DESCRIPTION OF THE DRAWINGS

The object and features of the present invention will become more readily apparent from the following detailed description of the preferred embodiments taken in conjunction with the accompanying drawings in which:
Fig. 1 is a circuit illustration of an arrangement of a high-pass filter to be used in a high-frequency circuit;
Fig. 2 is an illustration of the Fig. 1 circuit arrangement formed on a printed board according to the prior art;
Fig. 3 is an illustration of a circuit arrangement of a printed filter according to another embodiment of the prior art;
Figs. 4 and 5 are graphic illustrations for describing the filter characteristics due to prior art;
Fig. 6 is an illustration of a circuit arrangement of a printed filter according to a further embodiment of the prior art and
Fig. 7 is an illustration of a circuit arrangement of a printed filter according to the invention.

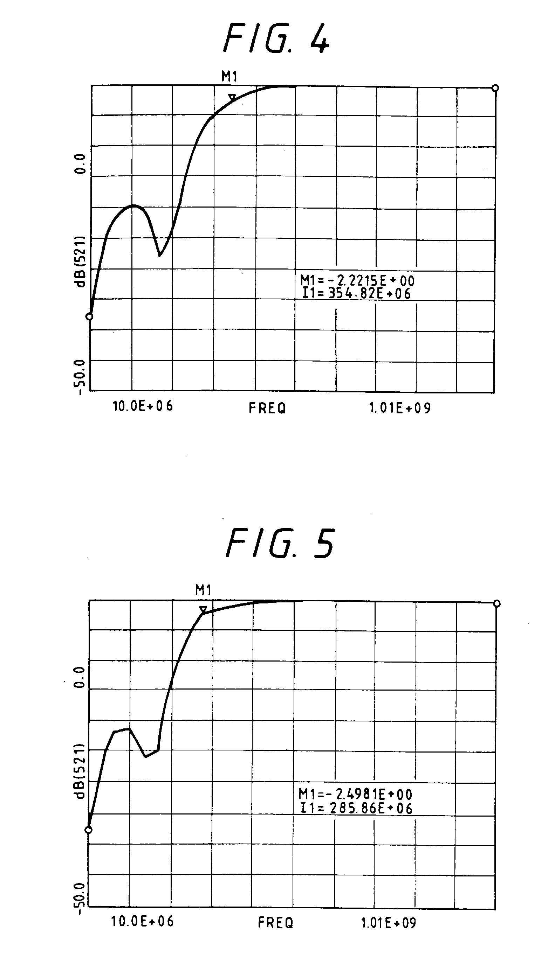

Referring now to Fig. 3, there is illustrated an arrangement of a printed filter according to another embodiment of the prior art. In Fig. 3, illustrated at numerals 1 to 3 are chip capacitors having the same structures as those in Fig. 2, and illustrated at numeral 4 is a spiral coil constructed with a print foil on a printed board, not shown. One difference from the above-described Fig. 2 prior art printed filter is that the spiral coil 4 is arranged such that the second turn and the third turn are electrically coupled to each other through a short-circuit line 5 having the foil width substantially equal to that of the turns.

With this arrangement, the spiral coil 4 is operable in substance as a spiral coil having two turns due to the action of the short-circuit line 5. Thus, for constructing a filter, in the case that the cutoff frequency of the filter is shifted to the higher side, the short-circuit line 5 is cut to result in the spiral coil 4 acting as a coil having three turns, whereby the cutoff frequency thereof can be corrected to the lower side.

Fig. 4 shows a filter characteristic to be obtained when the capacitor 1 = 2 PF, capacitor 2 = 5 PF, capacitor 3 = 82 PF and spiral coil 4 = 25 nH, for example. As shown in Fig. 4, the cutoff frequency is about 355 MHz. On the other hand, Fig. 5 illustrates a filter characteristic in the case that the short-circuit line 5 is cut. As illustrated in Fig. 5, the cutoff frequency becomes about 286 MHz. The cutting of the short-circuit line 5 can easily and automatically be performed by the laser trimming technique or the like. Here, in Fig. 4, M1 = -2.2215E + 00 means a point that the filter loss is -2.2215dB and I1 = 354.82E + 06 means that the frequency at the M1 point is 354.82MHz. That is, in the filter characteristic, the cutoff frequency which is a frequency at which the loss becomes -3dB is about 354MHz. Further, Fig. 5 shows that the frequency at the point that the filter loss becomes - 2.498dB (M1) is 285.86MHz (I1).

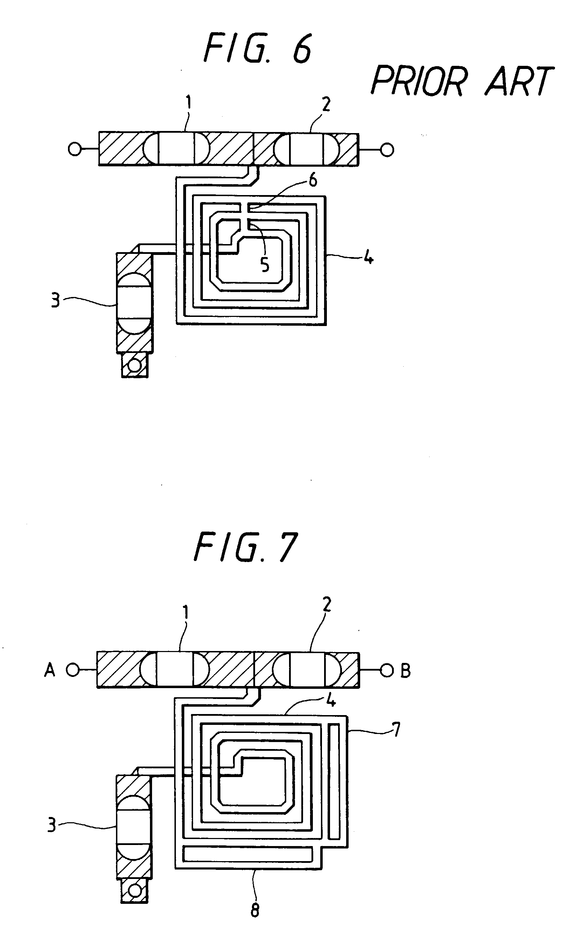

Secondly, a description will be made hereinbelow with reference to Fig. 6 in terms of a further embodiment of the prior art where parts corresponding to those in Fig. 3 are marked with the same numerals and the description thereof will be omitted for brevity. In Fig. 6, Similarly, a short-circuit line 5 is provided between the second and third turns of a spiral coil 4 so as to establish the electric connection therebetween, and a second short-circuit line illustrated at numeral 6 is also provided between the first and second turns of the spiral coil 4 so as to achieve the electric connection therebetween. This arrangement allows the spiral coil 4 to function as a coil comprising one turn in substance and can enlarge the adjusting range of the cutoff frequency because of taking three adjusting patterns.

Fig. 7 is an illustration of an arrangement of a printed filter according to the invention where parts corresponding to those in Fig. 6 are marked with the same numerals. In Fig. 7, illustrated at numeral 7 and 8 are short-circuit lines which are respectively provided in parallel at the sides (portions) of the outermost turn of a spiral coil 4. Each of the short-circuit lines 7 and 8 allows the reduction of the inductance of the corresponding side of the outermost turn to half. Thus, with the short-circuit lines 7 and/or 8 being cut, the inductance value of the spiral coil 4 can be arranged to be variable, thereby adjusting the dispersion of the filter characteristic. Unlike the above-described last embodiments of the prior art which effect the adjustment in unit of turn, the circuit arrangement of the invention allows adjustment in a fine range.

It should be understood that the foregoing relates to only a preferred embodiment of the present invention, and that it is intended to cover all changes and modifications of the embodiment of the invention herein used for the purposes of the disclosure, which do not constitute departures from the scope of the invention.

## Claims

1. A printed filter comprising a spiral coil (4) formed by a conductive foil on a printed board so as to have a plurality of turns, at least one cut-allowable short-circuit line (7, 8) being provided in parallel to a portion of an outermost turn of said spiral coil so that a characteristic of said filter is changeable by cutting said short-circuit line.

2. A printed filter as claimed in claim 1, wherein said spiral coil (4) is formed by a conductive foil and said short-circuit line is constructed with a conductive foil similar to that of said spiral coil.

## Patentansprüche

1. Ein gedruckter Filter mit einer Spiralspule (4), die durch eine leitende Folie auf einer gedruckten Platine dazu gebildet ist, eine Vielzahl von Windungen aufzuweisen, wobei zumindest eine schnittermöglichende Kurzschlußleitung (7, 8) parallel zu einem Teil einer äußersten Windung der Spiralspule vorgesehen ist, so daß eine Kennlinie des Filters durch Schneiden der Kurzschlußleitung geändert werden kann.

2. Ein gedruckter Filter nach Anspruch 1,
worin die Spiralspule (4) durch eine leitende Folie gebildet ist und die Kurzschlußleitung mit einer leitenden Folie ähnlich zu jener der Spiralspule gebildet ist.

## Revendications

1. Filtre imprimé comprenant un enroulement en spirale (4) formé par une feuille conductrice sur une plaquette imprimée de façon à avoir plusieurs spires, au moins une ligne de court-circuit (7, 8) qui peut être coupée étant placée en parallèle à une partie de la spire la plus extérieure dudit enroulement en spirale de sorte que l'on peut modifier une caractéristique dudit filtre en coupant ladite ligne de court-circuit.

2. Filtre imprimé selon la revendication 1, dans lequel ledit enroulement en spirale (4) est fait d'une feuille conductrice et ladite ligne de court-circuit est construite avec une feuille conductrice semblable à celle dudit enroulement en spirale.
